# EUROPEAN PATENT APPLICATION

(11) **EP 1 494 284 A1**
(43) Date of publication of application: **05.01.2005**
(21) Application number: 03291609.0
(22) Date of filing: 30.06.2003
(51) Int. Cl.: H01L 23/60, H01L 23/62

(54) **Overvoltage protection device**

(71) Applicant: Freescale Semiconductor, Inc., Austin, Texas 78735 (US)
(72) Inventor: Zecri, Michel, 31770 Colomiers (FR); Chaptal, Jean-Louis, 31100 Toulouse (FR); Bley, Vincent, 31062 Toulouse (FR); Lebey, Thierry, 31062 Toulouse (FR)
(74) Representative: Wharmby, Martin Angus

(57) **Abstract**

A voltage protection device comprising an integrated circuit associated with a first voltage variable element and a second voltage variable element; wherein the first voltage variable element has a first voltage variable characteristic and the second voltage variable element has a second voltage variable characteristic such that the first voltage variable element and the second voltage variable element have different voltage variable characteristics for allowing the first voltage variable element to provide voltage protection to the integrated circuit at a first voltage and the second voltage variable element to provide voltage protection to the integrated circuit at a second voltage.

## Description

The present invention relates to a voltage protection device.

Electro-Static Discharge ESD and Electrical Over Stress EOS can both produce high transient electric fields that can result in damage, if not destruction, of an electronic circuit.

Consequently, to minimise the risk of ESD and EOS damage to an electronic circuit ESD and EOS protection is typically incorporated within the electronic circuit design. However, the use of ESD/EOS protection devices can result in an increase in size of the required silicon area of an electronic circuit by up to 10% to 30%.

One solution to this problem, as described in US 6,211,544, has been the use of voltage variable material sandwiched between the contacts of an integrated circuit and a conducting rail.

Voltage variable material is designed to have a high electrical resistance value at low or normal operating voltages and currents but is arranged to switch to a low electrical resistance value in response to an essentially instantaneous change in voltage (e.g. at the start of an ESD and/or EOS transient).

Accordingly, on the occurrence of an ESD/EOS transient to an integrated circuit having voltage variable material sandwiched between the contacts of the integrated circuit and a conducting rail associated with the integrated circuit the voltage variable material goes low resistance allowing the ESD/EOS transient to be conducted away from the integrated circuit to the conducting rail.

However, the arrangement described in US 6,211,544 only applies to a limited voltage range and requires the addition of one or more discrete voltage suppression devices, for example a diode, thyristor or transistor, to provide protection across a wider range of voltages

It is desirable to improve this situation.

In accordance with a first aspect of the present invention there is provided a voltage protection device according to claim 1.

This provides the advantage of allowing ESD/EOS protection to be provided outside of a silicon die, thereby minimising the size of required silicon, while also providing protection over a wide range of ESD/EOS transient voltages.

In accordance with a second aspect of the present invention there is provided a method for manufacturing a voltage protection device according to claim 10.

An embodiment of the invention will now be described, by way of example, with reference to the drawings, of which:
Figure 1 shows a voltage protection device according to a first embodiment of the present invention;
Figure 2 illustrates the voltage variable characteristics of ZnO material for an element 40um and 50um in height;
Figure 3 shows a voltage protection device according to a second embodiment of the present invention;
Figure 4 shows a voltage protection device according to a third embodiment of the present invention;

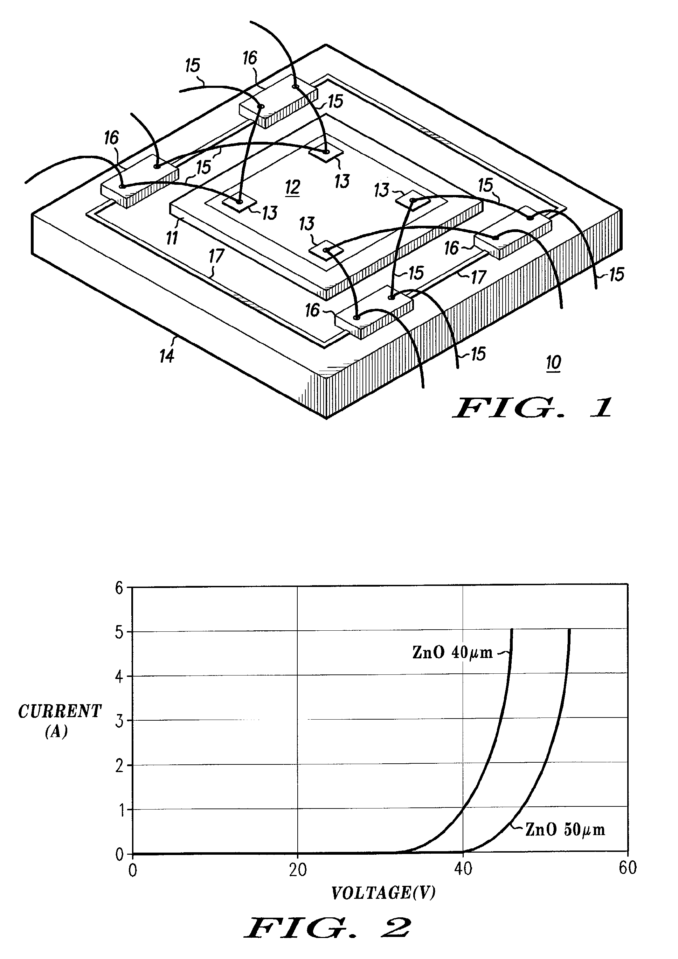

Figure 1 shows a voltage protection device 10 (i.e. a substrate voltage suppressor SVS) according to a first embodiment of the present invention. The SVS has a silicon wafer 11 having a functional die area 12 and a plurality of conductive input/output pads 13, which for the purposes of this embodiment consist of four pads, however the silicon wafer 11 could have any number of pads suitable for the functionality of the silicon wafer 11. The input/output pads 13 are coupled to the functional die area 12 where the functional die area 12 incorporates an integrated circuit.

The silicon part 11 is mounted on a lead frame 14 with each input/output pad 13 being coupled to appropriate input/output lines 15 with the appropriate input/output lines 15 additionally being connected to a respective element of voltage variable material 16 where each voltage variable element 16 is arranged to have different voltage variable characteristics, as described below. The respective voltage variable elements 16 are mounted on the lead frame 14 via a conductive element 17, where the conductive element 17 is connected to a ground rail or a positive/negative power supply rail (not shown).

At normal operating voltages (e.g. 3 V) the voltage variable materials of the voltage variable elements 16 exhibit a relatively high electrical resistance thereby ensuring that any voltage signals on the input/output lines 15 are conducted to the input/output pads 13 of the silicon area.

However, on application of an EOS or ESD transient voltage the voltage variable materials of the voltage variable elements 16 switch to a relatively low electrical resistance which causes the input/output lines 15 to be electrically connected to the conductive element 17. Consequently, the voltage variable elements 16 create a conductive path away from the silicon chip when an EOS or ESD transient voltage is applied to the silicon chip 11, thereby ensuring that the integrated circuit on the silicon chip 11 is protected from the harmful affects of the EOS or ESD transient energy.

The plurality of voltage variable elements 16 associated with the silicon die 12 are arranged to have different voltage variable characteristics such that the voltage at which each voltage variable element 16 switches to a relatively low electrical resistance is different, thereby providing voltage protection for a wide range of voltages.

US 4977357 describes how the non-linear characteristics of voltage variable material is determined by the inter-particle spacing within the binder as well as by the electrical properties of the insulating binding.

To provide protection over the range of voltages covered by the different elements 16 all the input/output lines 15 to/from the input/output pads 13 are connected to each of the voltage variable elements 16. To ensure that a short circuit does not occur between the different input/output lines 15 the height between each connection should be different.

One technique for providing different voltage variable characteristics using the same material is to vary the thickness of the individual elements. For example, one well known technique for creating elements of ceramic material (e.g. ZnO), a well known voltage variable material, having different heights is to sinter or pile-up the ceramic material until the required height is obtained.

Figure 2 illustrates the voltage variable characteristics of ZnO material for an element of 40um and 50um.

The ESD protection provided by the voltage variable material is defined by its static (DC) and dynamic (TLP) characteristics. As described below, the protection is provided by causing a short-circuit to occur for rapid changes in voltage, which could damage the circuit. The protection should be inactive during normal operating modes and arranged to be triggered for an electrical over voltage before the breakdown voltage of the protected devices is reached. As shown in figure 2, for DC measurements of 50 µm ZnO thickness, the current absorption is quasi zero before 30V after that the voltage increases rapidly, and the TLP shows that the dynamic breakdown voltage of this protection is around 40V. This 50µm ZnO could be used to protect a circuit input with 25V of normal operating mode and more of 40 V of breakdown voltage (typically for automotive applications).

Alternatively, however, different types of voltage variable materials, having different voltage variable characteristics can by used, where the type of materials are selected to provide EOS/ESD protection over a required voltage range.

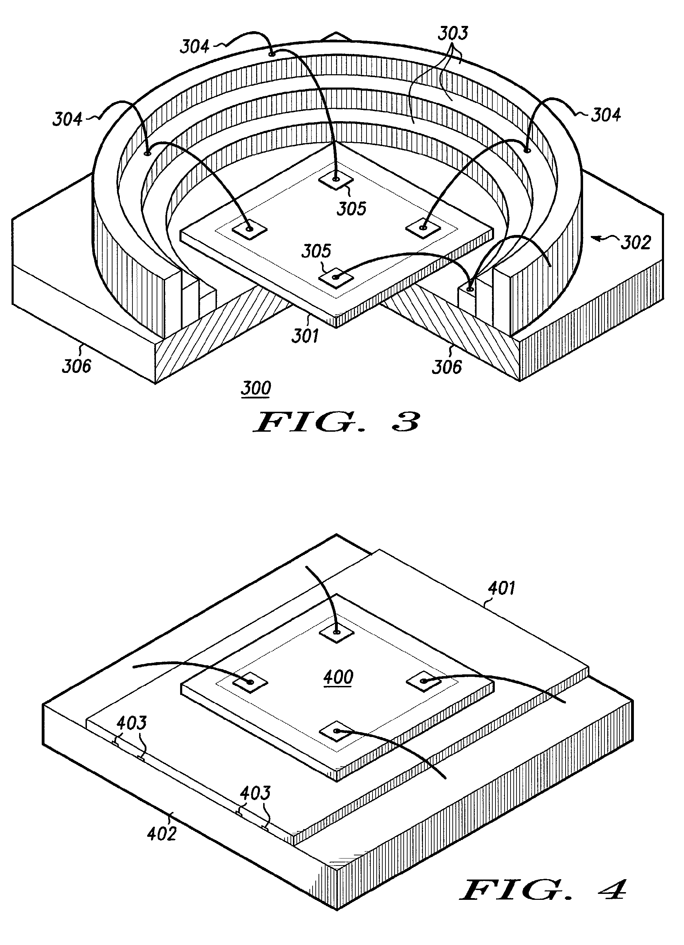

Figure 3 shows a SVS 300 according to a second embodiment of the present invention. The SVS has a silicon die 301 the same as that described in the first embodiment above; however, the four individual voltage variable elements have been replaced with a single voltage variable component 302 having a plurality of ring elements 303 with each ring element having a different height to the other ring elements. As a consequence of the different heights of the individual ring elements 303 each ring element 303 has a different voltage variable characteristic to the other ring elements, where the heights of the ring elements are selected to provide the required EOS/ESD voltage protection range. As for the first embodiment described above, the input/output lines 304 are connected to the input/output pads 305 of the silicon die 301 and to the ring elements 303 of the voltage variable component 302. The different thickness can be obtained by successive rings or directly patterned in the massive material. The connection with variable material can be made directly on the material itself by using an adapted solder join, however, any suitable means of connecting can be used. The connection could also be made if the material is metallized on the both sides.

The voltage variable component 302 is mounted on a conductive element 306 such that the elements 303 of the voltage variable component 302 create a conductive path away from the silicon die 301 when an EOS or ESD transient voltage is applied to the silicon wafer 301, thereby ensuring that the integrated circuit on the silicon wafer 301 is protected from the harmful affects of the EOS or ESD transient energy.

Figures 4 and 5 illustrate examples of different SVS having a voltage variable component, where the voltage variable component comprises voltage variable elements with different voltage variable characteristics.

Figure 4 illustrates an example of a silicon die 400 being mounted on a voltage variable component 401, having voltage variable elements (not shown) with different voltage variable characteristics, with the voltage variable component 401 being mounted on a lead frame 402 via a conductive element 403.

It will be apparent to those skilled in the art that the disclosed subject matter may be modified in numerous ways and may assume may embodiments other than the preferred forms specifically set out as described above, for example any suitable type of voltage variable material could be used and any multi-level voltage variable component that provides voltage variable elements having different voltage variable characteristics could be used.

## Claims

1. A voltage protection device comprising an integrated circuit associated with a first voltage variable element and a second voltage variable element; wherein the first voltage variable element has a first voltage variable characteristic and the second voltage variable element has a second voltage variable characteristic such that the first voltage variable element and the second voltage variable element have different voltage variable characteristics for allowing the first voltage variable element to provide voltage protection to the integrated circuit at a first voltage and the second voltage variable element to provide voltage protection to the integrated circuit at a second voltage.

2. A voltage protection device according to claim 1, wherein the first voltage variable element and the second voltage variable element form a single component.

3. A voltage protection device according to claim 2, wherein the first voltage variable element and the second voltage variable element of the single component form a multi-ring arrangement.

4. A voltage protection device according to any preceding claim, wherein the first voltage variable characteristic is a first height of the first voltage variable element and the second voltage variable characteristic is a second height of the second voltage variable element.

5. A voltage protection device according to any of claims 1 to 3, wherein the first voltage variable characteristic is a first type of voltage variable material and the second voltage variable characteristic is a second type of voltage variable material.

6. A voltage protection device according to claim 5, wherein at least one of the first type of voltage variable material and the second type of voltage variable material is a ceramic material.

7. A voltage protection device according to claim 6, wherein the ceramic material is ZnO.

8. A voltage protection device according to any preceding claim, wherein the first voltage variable element and the second voltage variable element form part of an integrated passive device for coupling to the integrated circuit.

9. An electronic device incorporating a voltage protection device according to any preceding claim.

10. A method for manufacturing a voltage protection device comprising producing a first voltage variable element having a first voltage variable characteristic and a second voltage variable element having a second voltage variable characteristic such that the first voltage variable element and the second voltage variable element have different voltage variable characteristics and associating the first voltage variable element and the second voltage variable element to an integrated circuit for allowing the first voltage variable element to provide voltage protection to the integrated circuit at a first voltage and the second voltage variable element to provide voltage protection to the integrated circuit at a second voltage.
